# EUROPEAN PATENT SPECIFICATION

(11) **EP 3 830 611 B1**
(45) Date of publication and mention of the grant of the patent: **15.05.2024**
(21) Application number: 19749065.9
(22) Date of filing: 17.07.2019
(51) Int. Cl.: G01V 1/30, G01V 99/00, E21B 41/00, G06F 30/28

(54) **DETECTING FLUID TYPES USING PETROPHYSICAL INVERSION**
DETEKTION VON FLUIDTYPEN MITTELS PETROPHYSIKALISCHER INVERTIERUNG
DÉTECTION DE TYPES DE FLUIDE PAR INVERSION PÉTROPHYSIQUE

(30) Priority: 31.07.2018 US 201862712780 P; 08.07.2019 US 201962871479 P
(43) Date of publication of application: 09.06.2021
(73) Proprietor: ExxonMobil Technology and Engineering Company, Spring, TX 77389 (US)
(72) Inventor: SCHMEDES, Jan, Bellaire, TX 77401 (US); YANG, Di, Spring, TX 77381 (US)
(74) Representative: ExxonMobil Chemical Europe LLC
(86) International application number: PCT/US2019/042246
(87) International publication number: WO 2020/028044

(56) References cited:
- US-A1- 2011 208 431
- US-A1- 2015 362 623
- US-A1- 2017 212 275
- US-A1- 2018 156 932
- GUOZHONG GAO ET AL: "Joint petrophysical inversion of electromagnetic and full-waveform seismic data", GEOPHYSICS, SOCIETY OF EXPLORATION GEOPHYSICISTS, US, vol. 77, no. 3, 1 May 2012 (2012-05-01), pages WA3-WA18, XP001575526, ISSN: 0016-8033, DOI: 10.1190/GEO2011-0157.1 [retrieved on 2012-04-23] cited in the application
- DARIO GRANA ET AL: "Probabilistic petrophysical-properties estimation integrating statistical rock physics with seismic inversion", GEOPHYSICS, SOCIETY OF EXPLORATION GEOPHYSICISTS, US, vol. 75, no. 3, 1 May 2010 (2010-05-01), pages O21-O37, XP001554638, ISSN: 0016-8033, DOI: 10.1190/1.3386676
- THIERRY COLÉOU ET AL: "Petrophysical Seismic Inversion", SEG TECHNICAL PROGRAM EXPANDED ABSTRACTS 2005, 1 January 2005 (2005-01-01), pages 1355-1358, XP055636622, DOI: 10.1190/1.2147938
- Kumar Dhananjay: "A Tutorial on Gassmann Fluid Substitution: Formulation, Algorithm and Matlab Code", GEOHORIZONS, 31 January 2006 (2006-01-31), XP055417689, Retrieved from the Internet: URL:http://spgindia.org/geohorizon/jan_200 6/dhananjay_paper.pdf [retrieved on 2017-10-20]
- Cgg Geosoftware: "Jason - Advanced seismic reservoir characterization software", , 18 May 2016 (2016-05-18), pages 1-4, XP055637025, Retrieved from the Internet: URL:https://www.cgg.com/data/1/rec_docs/32 92_Jason_Overview_BR_1605.pdf [retrieved on 2019-10-29]
- KOLBJ/RNSEN ODD ET AL: "Bayesian AVO inversion to rock properties using a local neighborhood in a spatial prior model", THE LEADING EDGE, [Online] vol. 35, no. 5, 1 May 2016 (2016-05-01), pages 431-436, XP093034628, US ISSN: 1070-485X, DOI: 10.1190/tle35050431.1 Internet Retrieved from the Internet: URL:http://dx.doi.org/10.1190/tle35050431. 1> [retrieved on 2023-03-24]

## Description

### CROSS REFERENCE TO RELATED APPLICATION

This application claims the benefit of U.S. Provisional Patent Applications 62/712780, filed July 31, 2018 entitled "Fluid Saturation Model for Petrophysical Inversion" and 62/871479, filed July 8, 2019 entitled "Detecting Fluid Types Using Petrophysical Inversion".

### FIELD

This disclosure relates generally to the field of geophysical prospecting and, more particularly, to hydrocarbon management (including prospecting for hydrocarbons) and related data processing. Specifically, exemplary embodiments relate to methods and apparatus for improving computational efficiency and accuracy of petrophysical inversion techniques applicable to detecting fluid types.

### BACKGROUND

This section is intended to introduce various aspects of the art, which may be associated with exemplary embodiments of the present disclosure. This discussion is believed to assist in providing a framework to facilitate a better understanding of particular aspects of the present disclosure. Accordingly, it should be understood that this section should be read in this light, and not necessarily as admissions of prior art.

An important goal of geophysical prospecting is to accurately image subsurface structures to assist in the identification and/or characterization of hydrocarbon-bearing formations. Geophysical prospecting may employ a variety of data-acquisition techniques, including seismic prospecting, electromagnetic prospecting, well logging, etc. Such data may be processed, analyzed, and/or examined with a goal of identifying geological structures that may contain hydrocarbons.

An important type of geophysical data analysis is petrophysical inversion. Petrophysical inversion generally transforms elastic parameters, such as seismic velocity and density, to petrophysical properties, such as porosity and volume of clay (Vclay). For example, petrophysical inversion can transform compressional velocity, shear velocity, and density well logs to porosity and Vclay logs. As another example, petrophysical inversion can utilize elastic information from seismic data, including traditional images of reflectivity and tomographic velocity, to predict three-dimensional volumes of porosity and Vclay. As used herein, Vclay refers to rock volumes including anything that is not sand (e.g., shale). That is, we will treat clay and shale (and associated properties such as Vclay and Vshale) interchangeably with the recognition that they are not strictly the same from a mineralogical standpoint. For the present application's purposes, however, it is suitable to treat them interchangeably as one of the volumetric mineral end-members of subsurface rocks, the other one being sand. Furthermore, petrophysical inversion can include additional geophysical data types, namely electromagnetic data or resistivity, which tend to have a better sensitivity to water saturation than elastic parameters.

Petrophysical inversion typically utilizes a model of fluid saturation that recognizes the vertical and lateral distribution of hydrocarbons and water in a reservoir. For example, in the case of well logs, a one-dimensional fluid saturation model may be derived with analysis of traditional electric well logs using the Archie equation. Building a two-dimensional or three-dimensional fluid saturation model for petrophysical inversion is a significant technical challenge that involves analysis and interpretation of seismic data to laterally-bind reservoir extent and known or suspected fluid-contact surfaces. The depth of hydrocarbon-contact surfaces can be detected by log analysis if penetrated by a well or hypothesized from extrapolation of pressure trends. Remaining challenges include: what to do when contacts are not penetrated by a well, what to do away from the well when the time-to-depth relationship is uncertain, and how to handle the potential for variable hydrocarbon contacts, which potential increases with complex geology (e.g. separated fault blocks or stratigraphic barriers to flow).

Broadly, two categories of relationships are used to relate petrophysical properties to seismic data during petrophysical inversion. The first relationship type is referred to as a rock physics model (RPM). RPMs relate petrophysical rock properties, such as porosity and Vclay (or, equivalently as noted above, Vshale), and fluid (hydrocarbon or water) content to geophysical rock properties, such as compressional (P-wave) and shear (S-wave) velocities, and density. Geophysical rock properties depend on elastic rock properties, such as bulk and shear moduli. RPMs can be either inductive (empirical) or deductive (theoretical). RPMs can be mathematically linear or nonlinear. RPMs may be calibrated using direct well-bore measurements and collocated seismic data. The second relationship type is referred to as an angle-dependent amplitude model (ADAM). ADAMs relate amplitudes of reflected seismic waves that have traveled through the subsurface to changes in the geophysical properties of the rocks between one layer and the next, as well as the angle of incidence with which the wave impinged on the boundary. Consequently, changes in amplitude as a function of receiver offset ("amplitude-variation with offset," or "AVO"), and/or changes in amplitude as a function of receiver angle ("amplitude-variation with angle," or "AVA"), can be used to infer information about these elastic parameters. To take advantage of AVO and/or AVA, subsets of seismic reflection data corresponding to particular offsets (or angles) or small groups of offsets (or angles) can be processed into what are called angle stacks. ADAMs can be linear or nonlinear in mathematical representations.

KOLBJORNSEN ODD ET AL: "Bayesian AVO inversion to rock properties using a local neighborhood in a spatial prior model",THE LEADING EDGE vol. 35, no. 5, 1 May 2016 (2016-05-01), pages 431-436, ISSN: 1070-485X, DOI: 10.1190/tle35050431.1 discloses that the spatial structure of the subsurface is an important factor when interpreting seismic data. The Bayesian methodology is a valuable tool for integrating these spatial relations in the inversion process as it merges the information together and assesses the uncertainty of the model. In the everyday use of the Bayesian methodology, however, the computational cost is a challenge. It is described a new approach that utilizes a local neighborhood to include the spatial constraints and assess the uncertainties in the inversion using fast and parallelizable computations. The approach is applicable for both discrete lithology-fluid prediction and estimation of rock properties, such as porosity and saturation.

More efficient equipment and techniques to perform petrophysical inversion, including better fluid saturation modeling, would be beneficial.

### SUMMARY

The invention provides for a method for generating a fluid saturation model for a subsurface region according to claim 1.

Petrophysical inversion may be utilized for hydrocarbon management, such as reservoir characterization, causing a well to be drilled, and/or otherwise prospecting for hydrocarbons in a subsurface region. For example, petrophysical inversion may be utilized to generate a fluid saturation model (e.g., to predict if a reservoir is wet or hydrocarbon-bearing). Under a misfit-based approach, petrophysical inversion may be utilized both with brine flood and hydrocarbon flood assumptions. As a result, misfits under the two assumptions may be estimated and/or analyzed. Under a post-inversion classification-based approach, a petrophysical inversion may be utilized under a brine flood assumption. The petrophysical inversion may classify petrophysical parameters under specified rock types, which may include one or more artificial rock types. Under a classification-during-inversion approach, the rock types may be developed (e.g., learned) during an iterative series of petrophysical inversions.

### BRIEF DESCRIPTION OF THE DRAWINGS

So that the manner in which the recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of scope, for the invention may admit to other equally effective embodiments and applications, insofar as as they fall within the scope of the invention as set forth in the accompanying claims.

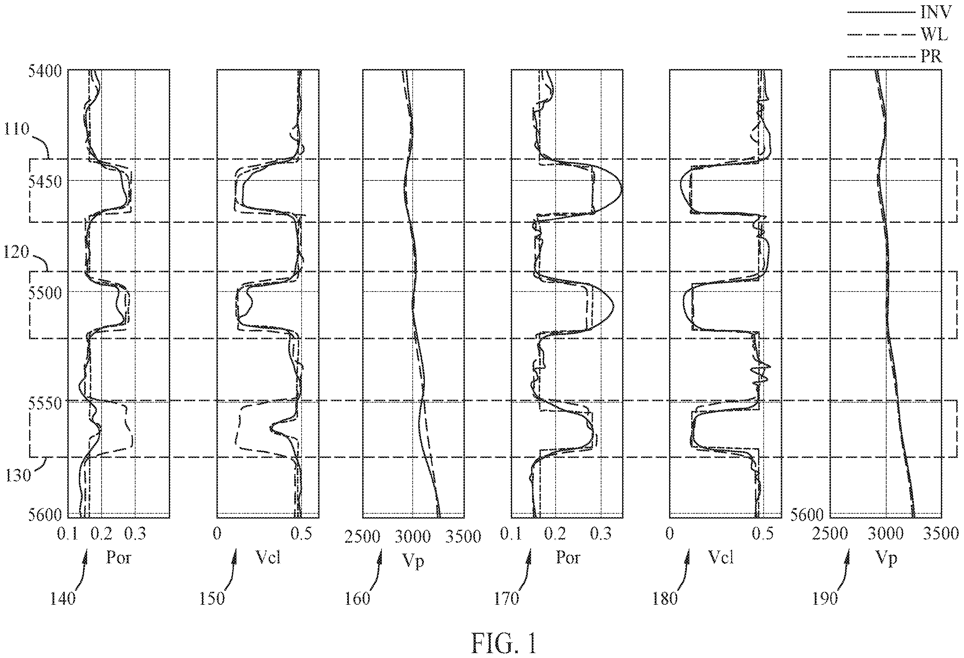

FIG. 1 illustrates a fluid saturation model mismatch as evidenced by geologic prior misfits and/or data misfits.

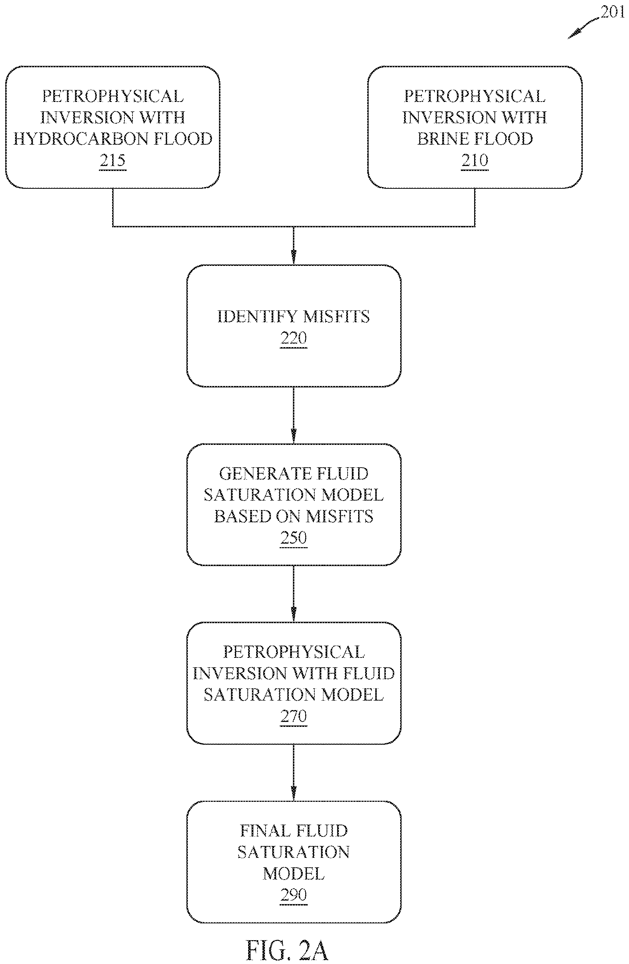

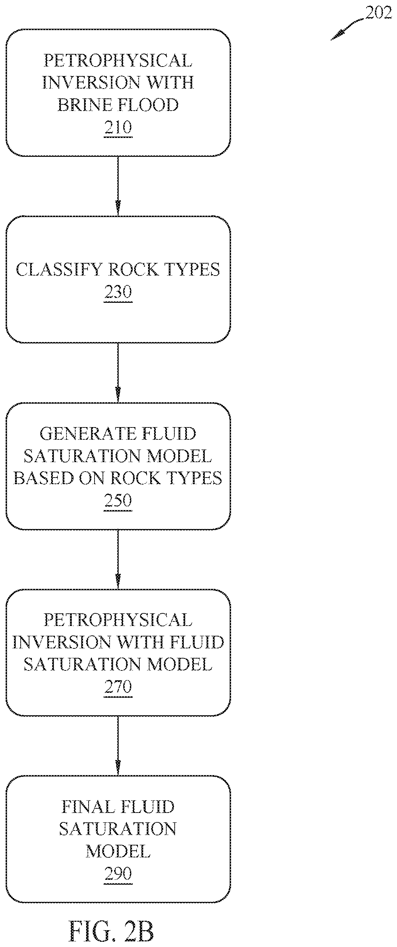

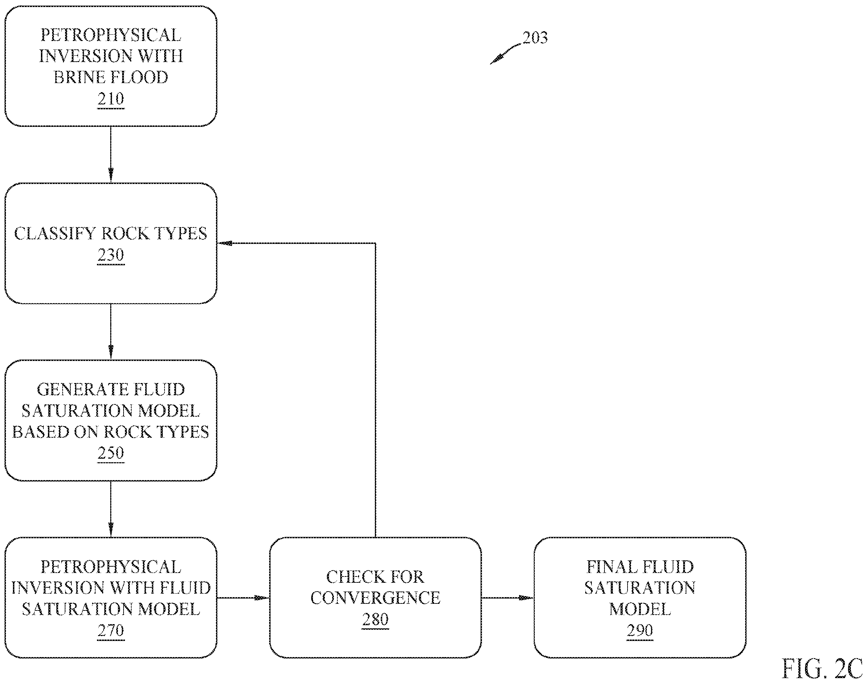

FIGs. 2A-2C illustrate exemplary methods of utilizing fluid saturation model mismatches in petrophysical inversion. FIG. 2A illustrates an exemplary method utilizing the misfit-based approach. FIG. 2B illustrates an exemplary method utilizing the post-inversion-classification approach. FIG. 2C illustrates an exemplary method utilizing the classification-during-inversion approach.

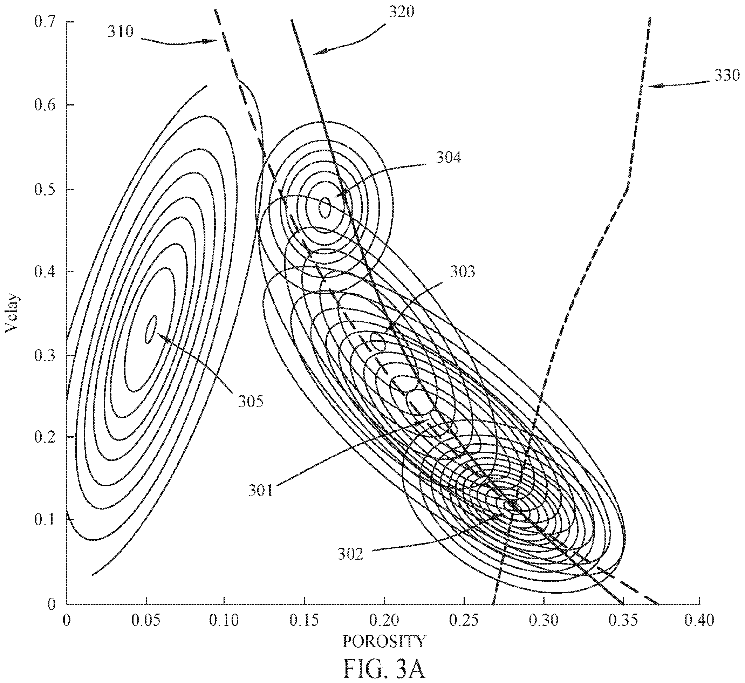

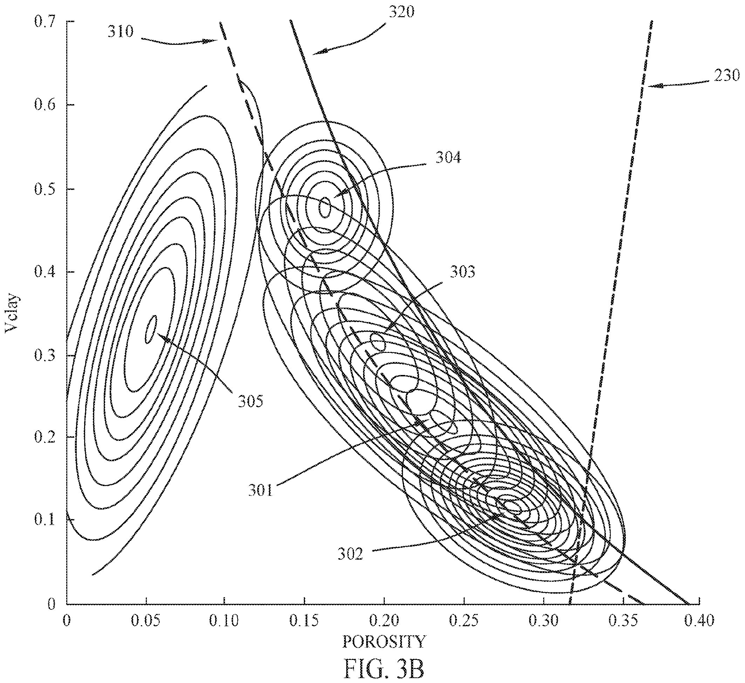

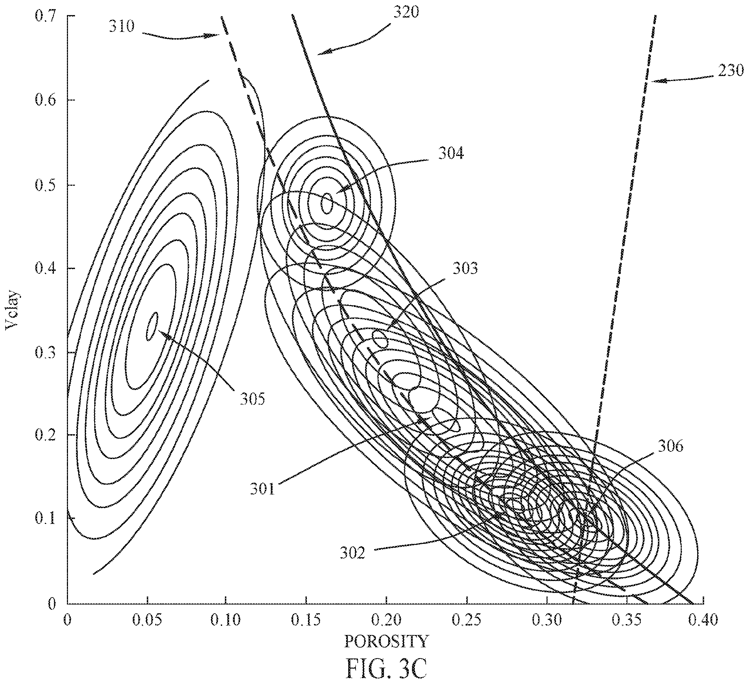

FIGs. 3A-3C illustrate one way to determine parameters for a suitable artificial rock type. FIG. 3A illustrates a cross-plot of porosity with Vclay, showing probability distributions of expected rock types and elastic parameters under a hydrocarbon flood assumption. FIG. 3B illustrates a cross-plot of porosity with Vclay, showing probability distributions of expected rock types and elastic parameters under a brine flood assumption. FIG. 3C illustrates a cross-plot of porosity with Vclay, showing an artificial rock type classified under the brine flood assumption.

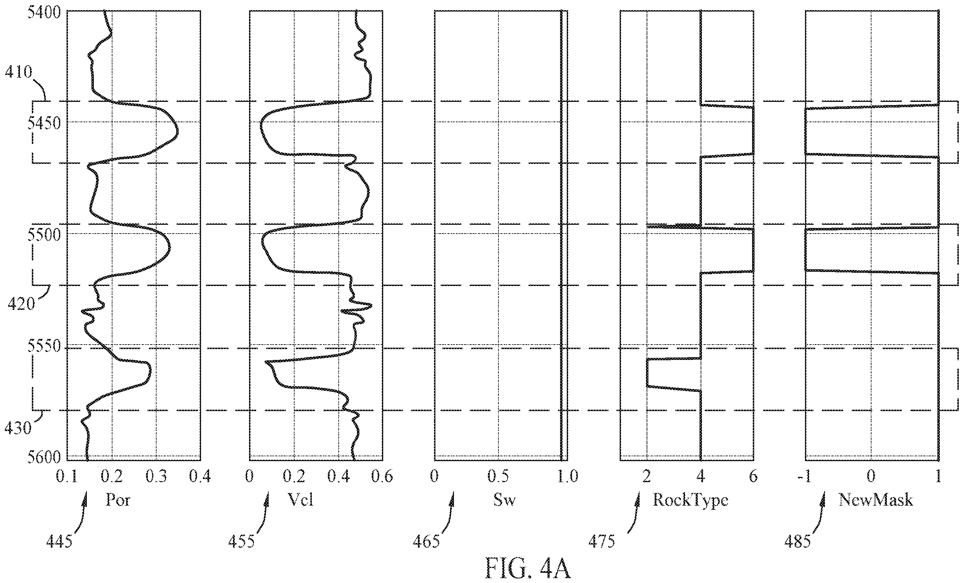

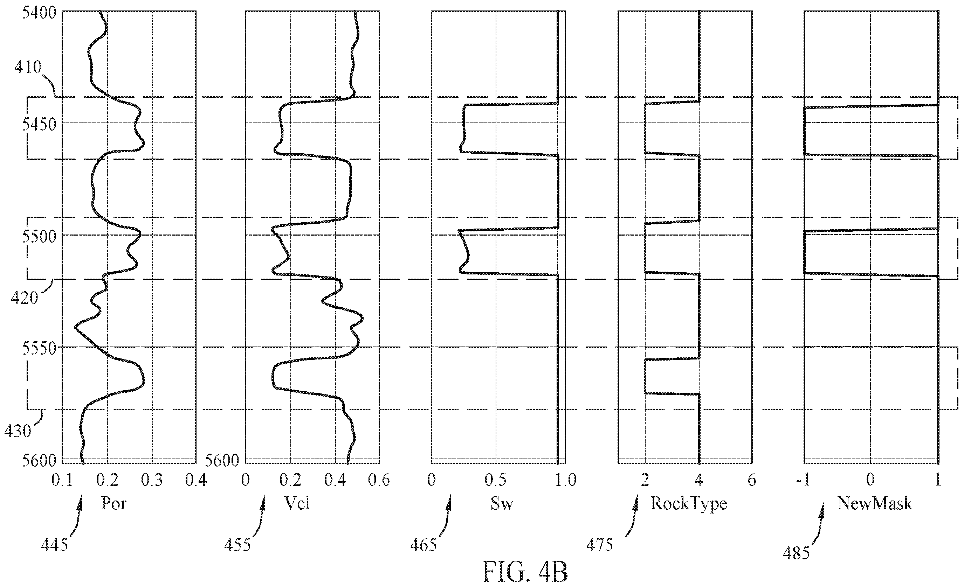

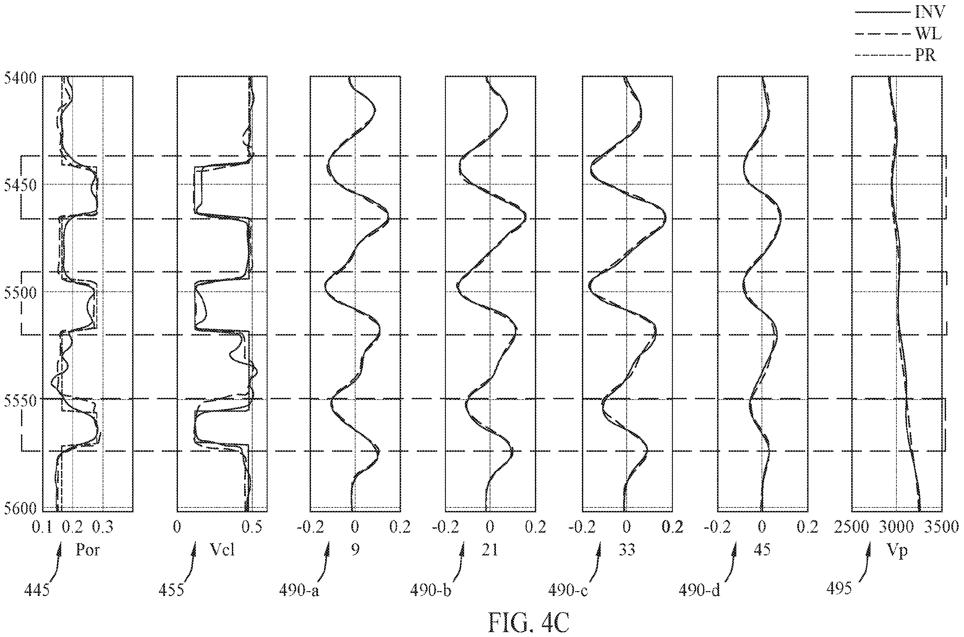

FIGs. 4A-4C illustrate results for the classification-during-inversion approach. FIG. 4A illustrates petrophysical parameters after the first iteration. FIG. 4B illustrates petrophysical parameters after the next iteration. FIG. 4C illustrates fluid saturation model mismatch as evidenced by geologic prior misfits and/or data misfits.

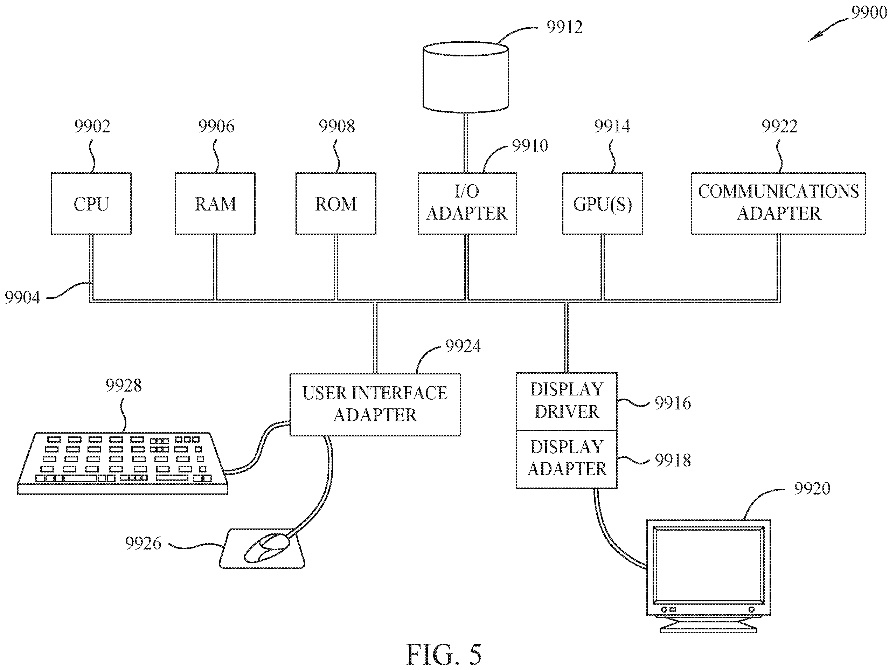

FIG. 5 illustrates a block diagram of a seismic data analysis system upon which the present technological advancement may be embodied.

### DETAILED DESCRIPTION

It is to be understood that the present disclosure is not limited to particular devices or methods, which may, of course, vary. It is also to be understood that the terminology used herein is for the purpose of describing particular embodiments only, and is not intended to be limiting. As used herein, the singular forms "a," "an," and "the" include singular and plural referents unless the content clearly dictates otherwise. Furthermore, the words "can" and "may" are used throughout this application in a permissive sense (i.e., having the potential to, being able to), not in a mandatory sense (i.e., must). The term "include," and derivations thereof, mean "including, but not limited to." The term "coupled" means directly or indirectly connected. The word "exemplary" is used herein to mean "serving as an example, instance, or illustration." Any aspect described herein as "exemplary" is not necessarily to be construed as preferred or advantageous over other aspects. The term "uniform" means substantially equal for each sub-element, within about ±10% variation. The term "nominal" means as planned or designed in the absence of variables such as wind, waves, currents, or other unplanned phenomena. "Nominal" may be implied as commonly used in the fields of seismic prospecting and/or hydrocarbon management.

As used herein, a fluid is a substance that deforms or flows under an applied shear stress, including phases of matter such as liquids and gases. Specifically relevant to hydrocarbon prospecting, the term "fluid" includes oil, water, brine, and natural gas (or simply "gas").

As used herein, "offset" refers to a distance between a source and a receiver in a geophysical survey.

The term "seismic data" as used herein broadly means any data received and/or recorded as part of the seismic surveying process, including particle displacement, velocity, and/or acceleration, pressure, reflection, shear, and/or refraction wave data. "Seismic data" is also intended to include any data or properties, including geophysical properties such as one or more of: elastic properties (e.g., P- and/or S-wave velocity, P-Impedance, S-Impedance, density, attenuation, anisotropy, and the like); seismic stacks (e.g., seismic angle stacks); compressional velocity models; and porosity, permeability, or the like, that the ordinarily skilled artisan at the time of this disclosure will recognize may be inferred or otherwise derived from such data received and/or recorded as part of the seismic surveying process. Thus, the disclosure may at times refer to "seismic data and/or data derived therefrom," or equivalently simply to "seismic data." Both terms are intended to include both measured/recorded seismic data and such derived data, unless the context clearly indicates that only one or the other is intended.

As used herein, "inversion" refers to any process whereby, for a quantity y known to depend on one or more variables *x* (e.g., collectively forming a model *m*(*x*)), inferring the specific values of *x* (or the specific model *m*(*x*)) that correspond to measured values of *y*. For example, a model may be derived from field data to describe the subsurface that is consistent with acquired data. For example, seismic inversion may refer to calculating acoustic impedance (or velocity) from a seismic trace, taken as representing the earth's reflectivity. Inverse problems frequently contain three elements: data, model parameters, and model structure. In the realm of petrophysical inversion, the data element is generally geophysical data such as seismic angle stacks, seismic velocities, resistivity, density, etc. In particular, such data is often obtained from a subsurface region of interest (e.g., the subsurface region for which a subsurface properties model is being generated via the inversion). In the realm of petrophysical inversion, the model parameters element generally comprises one or more petrophysical properties such as porosity, Vclay, Vshale, water saturation, lithology, etc. In the realm of petrophysical inversion, the model structure element is generally forward physics or statistical model relating data and model parameters; structure of petrophysical constraints; *a priori* concepts of porosity and Vclay distributions, etc.

As used herein, "facie" refers to rock characteristics reflective of origin and/or differentiation from other nearby rock units. Geological characteristics indicative of facies distinctions include petrophysical characteristics that control the fluid behavior (e.g., porosity and Vclay).

As would be understood by one of ordinary skill in the art with the benefit of this disclosure, a variety of petrophysical inversion techniques may be applicable herein. Exemplary petrophysical inversion techniques include: i) one-stage petrophysical inversion (Aleardi, 2018; US20180156932A1), ii) petrophysically-constrained Full Wavefield Inversion (FWI) (Zhang, Zhen-dong, Alkhalifah, Tariq, Naeini, Ehsan Zabihi, Sun, Bingbing, 2018, "Multiparameter elastic full waveform inversion with facies-based constraints," Geophysical Journal International, Vol 213, Issue 3, 2112-2127), and iii) joint inversion (Gao, Guozhong, Abubakar, Aria, Habashy, Tarek M, 2012, "Joint petrophysical inversion of electromagnetic and full-waveform seismic data," Geophysics, Vol 77, Issue 3, WA3-WA18). For example, joint inversion may include any of the other petrophysical inversion techniques wherein seismic data is used jointly with other geophysical data, such as gravity, magnetics, and/or electromagnetic geophysical data. Applicable types of petrophysical inversion utilize a spatial depiction, or model, of fluid saturation that allow transformation from elastic to petrophysical parameters. Typically, a one-stage petrophysical inversion utilizes the fluid model as an integral component that allows the method to solve directly for petrophysical parameters from seismic data. While petrophysical inversion is historically thought of as a post-stack reservoir characterization method, recent advances in FWI also provide techniques applicable to the current disclosure. For example, petrophysically-constrained FWI may be analogous to a one-stage petrophysical inversion, but the forward modeling engine is FWI, and application of petrophysical constraints (e.g., to a fluid model) is performed inside the FWI iteration loop. Petrophysical inversion (e.g., lithology inversion) may be used to predict petrophysical properties such as sand (or shale) volume and porosity in sub-surface rocks. Specifically, petrophysical inversion may predict facies-based petrophysical properties from geophysical products such as seismic data and Full Wavefield Inversion products along with an assessment of uncertainty. Exemplary techniques for petrophysical inversion can be found in co-pending U.S. Patent Publication No. 2018/0156932, entitled "Method for Estimating Petrophysical Properties for Single or Multiple Scenarios from Several Spectrally Variable Seismic and Full Wavefield Inversion Products," and filed October 19, 2017. Petrophysical inversion techniques are applicable to solve a variety of technical problems. Petrophysical inversion techniques may utilize a broad range of computational complexity and/or a multi-dimensional fluid saturation model.

As used herein, the term "facies-based inversion" in general refers to petrophysical inversion techniques which match geophysical input data, such as seismic data, and infer facies for locations in a subsurface region. Facies-based inversion generally utilizes additional input parameters of facies, described in a petrophysical parameter space. A simple example of facies input includes a rock type probability distribution characterized by a mean value and a covariance matrix. The inclusion of facies input may beneficially add low frequency information. Generally, the output of a facies-based inversion includes petrophysical parameters in an absolute frequency band (e.g., low frequencies, near to or about 0 Hz). Exemplary techniques for facies-based inversion can be found in aforementioned U.S. Patent Publication No. 2018/0156932.

The terms "velocity model," "density model," "physical property model," or other similar terms as used herein refer to a numerical representation of parameters for subsurface regions. Generally, the numerical representation includes an array of numbers, typically a 2-D or 3-D array, where each number-which may be called a "model parameter"-is a value of velocity, density, or another physical property in a cell, where a subsurface region has been conceptually divided into discrete cells for computational purposes. For example, the spatial distribution of velocity may be modeled using constant-velocity units (layers) through which ray paths obeying Snell's law can be traced. A 3-D geologic model (particularly a model represented in image form) may be represented in volume elements (voxels), in a similar way that a photograph (or 2-D geologic model) is represented by picture elements (pixels). Such numerical representations may be shape-based or functional forms in addition to, or in lieu of, cell-based numerical representations.

As used herein, "hydrocarbon management" or "managing hydrocarbons" includes any one or more of the following: hydrocarbon extraction; hydrocarbon production (e.g., drilling a well and prospecting for, and/or producing, hydrocarbons using the well; and/or causing a well to be drilled, e.g., to prospect for hydrocarbons); hydrocarbon exploration; identifying potential hydrocarbon-bearing formations; characterizing hydrocarbon-bearing formations; identifying well locations; determining well injection rates; determining well extraction rates; identifying reservoir connectivity; acquiring, disposing of, and/or abandoning hydrocarbon resources; reviewing prior hydrocarbon management decisions; and any other hydrocarbon-related acts or activities, such activities typically taking place with respect to a subsurface formation. The aforementioned broadly include not only the acts themselves (e.g., extraction, production, drilling a well, etc.), but also or instead the direction and/or causation of such acts (e.g., causing hydrocarbons to be extracted, causing hydrocarbons to be produced, causing a well to be drilled, causing the prospecting of hydrocarbons, etc.).

As used herein, "obtaining" data generally refers to any method or combination of methods of acquiring, collecting, or accessing data, including, for example, directly measuring or sensing a physical property, receiving transmitted data, selecting data from a group of physical sensors, identifying data in a data record, and retrieving data from one or more data libraries. For example, a seismic survey may be conducted to acquire the initial data (noting that these and other embodiments may also or instead include obtaining other geophysical data in addition or, or instead of, seismic data-such as obtaining electrical resistivity measurements). In these and other embodiments, models may be utilized to generate synthetic initial data (e.g., computer simulation). In some embodiments, the initial data may be obtained from a library of data from previous seismic surveys or previous computer simulations. In some embodiments, a combination of any two or more of these methods may be utilized to generate the initial data.

The term "label" generally refers to identifications and/or assessments of correct or true outputs provided for a given set of inputs. Labels may be of any of a variety of formats, including text labels, data tags (e.g., binary value tags), pixel attribute adjustments (e.g., color highlighting), n-tuple label (e.g., concatenation and/or array of two or more labels), etc.

If there is any conflict in the usages of a word or term in this specification and one or more patent or other documents that may be incorporated herein by reference, the definitions that are consistent with this specification should be adopted for the purposes of understanding this disclosure.

One of the many potential advantages of the embodiments of the present disclosure is that accurate fluid saturation models may be efficiently developed. Other potential advantages include one or more of the following, among others that will be apparent to the skilled artisan with the benefit of this disclosure: working in the petrophysical parameter space, well log data, and prior fit may be utilized as criteria to determine fluid types; some techniques utilize only a single inversion routine to identify hydrocarbon-bearing sands; and some techniques utilize an artificial rock type to model implausible sets of petrophysical parameters. Embodiments of the present disclosure can thereby be useful in the discovery and/or extraction of hydrocarbons from subsurface formations.

A petrophysical inversion (e.g., facies-based inversion) will generally use a fluid saturation model of the subsurface region. When the fluid saturation model mismatches the geophysical data (i.e., makes incorrect fluid assumptions for at least a portion of the subsurface region), the petrophysical inversion pushes the inversion solution (predicted result) away from the prior distributions. For example, if a hydrocarbon reservoir is inverted under an assumption that it is wet (e.g., containing brine), the inverted reservoir sand will be predicted to be too "clean" (i.e., have too high porosity and/or too low Vclay). Hence the prior distribution assumption is violated if the wrong fluid is assumed in the fluid saturation model.

FIG. 1 illustrates fluid saturation model mismatch as evidenced by geologic prior misfits and/or data misfits. Graphs 140, 150, and 160 illustrate inversion parameters under a hydrocarbon flood fluid saturation model. Graphs 170, 180, and 190 illustrate inversion parameters under a brine flood fluid saturation model. Along the horizontal axes, graphs 140 and 170 illustrate porosity parameters, graphs 150 and 180 illustrate volume of clay (Vclay or Vcl) parameters, and graphs 160 and 190 illustrate P-wave velocity (Vp) parameters. The vertical axis represents signal time, which can be simply converted to reflector depth. Each graph illustrates stacked reservoir sands in zones 110, 120, and 130. Well log data (e.g., from a petrophysical model) is illustrated as line WL in each of the graphs 140, 150, 170, and 180. Such well log data may be utilized to generate seismic data and/or P-wave velocity data. In this example, for the forward modeling of the seismic data and P-wave velocity data, the zones 110 and 120 contain hydrocarbons, and zone 130 contains brine. In each of the graphs 140, 150, 170, and 180, the line INV is the inverted result (predicted result), and the line PR is the final prior distribution.

Graphs 140, 150, and 160, being inversion parameters under a hydrocarbon flood fluid saturation model, assume the sands in all three zones are hydrocarbon bearing. Note that, for graphs 140 and 150, the predicted result (line INV) matches reasonably well with the prior distribution (line PR), which also matches reasonably well with the true model (e.g., well log data represented by line WL). However, in zone 130 of these two graphs, although the predicted result (line INV) matches reasonably well with the prior distribution (line PR), the forward modeling does not correctly predict the lower reservoir (zone 130) for the true model (line WL) due to the wrong fluid assumption (e.g., a misfit of geologic prior). The wet sand of zone 130 is under-predicted in porosity. A data misfit in P-wave velocity can also be seen in zone 130 of graph 160.

On the other hand, graphs 170, 180, and 190, being inversion parameters under a brine flood fluid saturation model, assume the sands in all three zones contain brine. Note that, for graphs 170 and 180, the predicted result (line INV) does not match well with either the prior distribution (line PR) or the true model (line WL) in zones 110 and 120. However, in these two graphs, for zone 130, the predicted result (line INV) matches reasonably well with the prior distribution (line PR) which also matches reasonably well with the true model (line WL). The prior misfits in zones 110 and 120 indicate that the hydrocarbon sands (of zones 110 and 120) are predicted to be too clean; specifically the porosity is over-predicted. It should be understood that a petrophysical inversion converging upon a correct result should not have a predicted result (line INV) with a significantly higher porosity than the prior distributions (line PR). Hence, zones 110 and 120 illustrate a large prior misfit in graph 170. Moreover, the prior misfits in zones 110 and 120 in graphs 170 and 180 are larger than those of graphs 140 and 150, respectively. Consequently, FIG. 1 illustrates a fluid saturation model mismatch for the brine flood in zones 110 and 120, and for the hydrocarbon flood in zone 130.

Fluid saturation model mismatches in petrophysical inversion can be exploited in various ways to better predict the potential for locating hydrocarbons in a reservoir. Three approaches will be discussed below. The first two approaches are generally applicable post inversion, while the third approach may be implemented as part of a learning step during the inversion. It should be understood that each approach presupposes that data and/or models for a subsurface region have been appropriately obtained to facilitate elucidated actions. For example, each approach presupposes that an initial subsurface region model is obtained. A subsurface region model may be made up of cells identified at locations in the subsurface region. Each cell in the subsurface region model may contain a representation of pore space, for example percentage of pore space. The pore space may determine the amount of fluid that may occupy the pore and/or cell. Each cell in the subsurface region model may contain a representation of volume of clay, for example percentage of volume of clay. The volume of clay may determine the amount of bound-water, and thus decrease the amount of additional fluid that may occupy the pore and/or cell. Seismic data may be utilized to identify possible reflectors, layers, and/or geology of the subsurface formation of interest.

### Misfit-based Approach

The misfit-based approach utilizing fluid saturation model mismatches in petrophysical inversion utilizes a variant of "velocity flooding" to solve problems associated with accurate and efficient modeling of a subterranean region remote from a wellbore (or other location with obtainable samples). Typically, velocity flooding includes generating a velocity model where all of a subterranean reservoir, or large portions thereof, has a constant, or linearly-increasing gradient, velocity. The first iteration would fill the model with water velocity, the second would have a simple velocity gradient profile for sediments below the interpreted water bottom, the third would have a constant velocity of salt below the interpreted top salt, etc. The complexity of the model generally grows with each subsequent iteration. In some embodiments, instead of starting with "floods" of simple velocity profiles, the initial velocity model may simulate the filling of all (substantially all, or the vast majority thereof) available pore space of a fluid saturation model of a subterranean region with a given fluid type - even recognizing that this is not a realistic representation of the subterranean region. This "flooding" process is repeated iteratively with one or more different fluid types. Suitable techniques for velocity flooding can be found in co-pending U.S. Patent Application Serial No. 67/712,780, entitled "Fluid Saturation Model for Petrophysical Inversion," and filed July 31, 2018.

The misfit-based approach makes use of the fact that a mismatched fluid saturation model drives the inversion to produce larger misfits, both for the prior distribution and for the data term of the objective function. FIG. 2A illustrates an exemplary method 201 utilizing the misfit-based approach. The method 201 begins by performing a first petrophysical inversion under a hydrocarbon flood assumption at block 215, and by performing a second petrophysical inversion under a brine flood assumption at block 210. The actions of blocks 210 and 215 may occur in parallel, sequentially, and/or in any order. Each of the inversions generates results (e.g., resulting predicted properties in a subsurface property model), such as one or more of porosity, Vclay, seismic data, and Vp results. In certain of these embodiments, an inversion generates a model of one of the aforementioned properties (noting that multiple inversions may be carried out to generate multiple subsurface property models, resulting in, for example, a model for each property). As illustrated in FIG. 1, a larger prior misfit will result if a hydrocarbon-bearing sand is inverted under a brine flood fluid saturation model. (That is, using data from a subsurface region of interest, and inverting for a given subsurface property(ies) (e.g., Por, Vclay, and/or Vp, as shown in Fig. 1) using a brine flood fluid saturation model, as opposed to a hydrocarbon flood fluid saturation model, may result in larger misfit of predicted property(ies) as compared to measured property(ies) of the subsurface region of interest.) Furthermore, because the prior will restrain the solution from predicting a more-correct result, the data (under the fluid saturation model mismatch) cannot be fit as well as for an inversion with a better fluid match (e.g., using a hydrocarbon flood fluid saturation model, for hydrocarbon-bearing sand). Misfits in the results of the two inversions (from blocks 210 and 215) may be identified at block 220. By comparing misfits for a hydrocarbon flood and a brine flood, zones of increased relative misfit may be identified. Such identified zones may correspond to zones where the fluid assumption was violated. Method 201 continues at block 250 where a fluid saturation model is generated based on the misfits from block 220. For example, zones may then be labeled as "wet sand" or "hydrocarbon sand" based on relative performance under the two inversions (from blocks 210 and 215). A final petrophysical inversion may be performed at block 270 starting with the fluid saturation model from block 250. The output of the method 201 may be the output of the inversion at block 270, including a final fluid saturation model at block 290. It will be appreciated that, although the above example is discussed in terms of inverting a hydrocarbon-bearing sand under a brine flood fluid saturation model, the same concepts could apply *vice versa* with respect to brine-saturated sand inverted under a hydrocarbon flood fluid saturation model.

### Post-inversion-classification approach

The post-inversion classification approach utilizing fluid saturation model mismatches in petrophysical inversion analyzes results of using a brine flood during the inversion. Any identified prior misfits and/or data misfits may lead to rock type classification with the use of an artificial (i.e., not petrophysically plausible) rock type. In other words, a rock type model may include the artificial rock type in exactly those locations that prior misfits and/or data misfits arise during the inversion iterations. The fluid saturation model may then be generated based on the locations of the predicted artificial rock type. Suitable techniques for inversion analysis with artificial/synthetic rock types can be found in co-pending U.S. Patent Application Serial No. 62/731,182, entitled "Reservoir Characterization Utilizing Resampled Seismic Data," and filed September 14, 2018.

FIG. 2B illustrates an exemplary method 202 utilizing the post-inversion-classification approach. The method 202 begins by performing a petrophysical inversion under a brine flood assumption at block 210. The petrophysical inversion takes as input several expected rock type classes, each specified by its respective petrophysical parameters. Output of the petrophysical inversion includes a model of the subsurface region as specified by petrophysical parameters.

Method 202 continues at block 230 where rock types are classified based on the petrophysical parameters from the petrophysical inversion of block 210. For example, rock types may be classified in petrophysical space (e.g., based on porosity and Vclay parameters). In some embodiments, classifying rock types at block 230 may include utilizing one or more artificial rock types. FIGs. 3A-C illustrate one way to determine parameters for a suitable artificial rock type. FIG. 3A illustrates a cross-plot of porosity (along the horizontal axis) with Vclay (along the vertical axis), showing probability distributions of expected rock types 301-305 (e.g., rock types used during the classification step in a conventional petrophysical inversion). For example, rock type 302 represents a clean reservoir sand, having high porosity and low Vclay. In FIG. 3A, iso-contours of elastic parameters under a hydrocarbon flood assumption for rock type 302 (more specifically, for the mean value of the probability distribution of rock type 302) are also plotted: S-wave velocity (Vs) at line 310, P-wave velocity (Vp) at line 320, and density at line 330. FIG. 3B illustrates a cross-plot of porosity with Vclay for the same reservoir with a brine flood assumption. Note in FIG. 3B that line 320 (Vp) and line 330 (density) are moved away from the clean sand rock type 302, indicating a geologic prior misfit. In FIG. 3C, an additional probability distribution is constructed for artificial rock type 306. The mean value of rock type 306 is at the intersection of line 320 (Vp) and line 330 (density) under the brine flood assumption. It is expected that performing a petrophysical inversion with a brine flood assumption with rock types 301-306 will correctly classify wet sands (e.g., zone 130 of FIG. 1) as rock type 302, while hydrocarbon sands (e.g., zones 110 and 120 of FIG. 1) will be classified as artificial rock type 306. Thus, the inverted porosity and Vclay from block 210 may be utilized to classify rock types at block 230, including potentially one or more artificial rock types, which may be indicative of a prior misfit and/or data misfit.

In some embodiments (not illustrated in FIG. 2B), further iterations of blocks 210 and 230 perform one or more petrophysical inversions under a brine flood assumption with successive rock type models updated with one or more artificial rock types. By introducing these additional artificial rock types during the inversions, the results are allowed to diverge further in parameter space. This may produce somewhat better overall results.

In some embodiments, a trained machine learning system may be utilized to classify rock types (e.g., based on cross-plots of porosity and Vclay) at block 230. In some embodiments, expert interpretation of inverted porosity and Vclay in the parameter space can be used to carve out potential hydrocarbon sands, by e.g. drawing arbitrary polygons to select all points not consistent with the rock types shown in FIG. 3A. In some embodiments multiple artificial rock types are selected for multiple types of reservoirs sands. For example, an additional rock type may be created based on the iso-contours of line 310 under a brine assumption.

Method 202 continues at block 250 where a fluid saturation model is generated based on the rock types from block 230. For example, expert interpretation may be utilized to build a fluid saturation model, e.g., by removing small scale artifacts that could result from misclassification. A final petrophysical inversion may be performed at block 270 starting with the fluid saturation model from block 250. The output of the method 202 may be the output of the inversion at block 270, including a final fluid saturation model at block 290.

In some embodiments, the misfit-based approach and the post-inversion classification approach may be utilized in conjunction to lessen or remove ambiguity between an actual fluid response and an unexpected lithology variation. For example, if the prior misfit actually identifies an area of higher porosity sand that is not fully captured in the modeled rock types, the post-inversion classification approach may identify the area as hydrocarbon-bearing sand in a brine flood inversion, while the data misfit-based approach would suggest that a wet, but more porous, sand is more probable.

### Classification-during-inversion approach

The classification-during-inversion approach utilizing fluid saturation model mismatches in petrophysical inversion allows the fluid type to be changed during the inversion. For example, the fluid model may be constructed during the inversion. This approach follows a similar strategy as the post-inversion classification approach, in that both approaches utilize one or more artificial rock types. In the classification-during-inversion approach, the artificial rock type is added as a prior facie at the beginning of the inversion.

FIG. 2C illustrates an exemplary method 203 utilizing the classification-during-inversion approach. The method 203 begins by performing a petrophysical inversion under a brine flood assumption at block 210. The iterative methodology of the inversion generates porosity and Vclay results for each iteration. FIGs. 4A-4C illustrate results for the classification-during-inversion approach. Each graph of FIGs. 4A-4C illustrates stacked reservoir sands in zones 410, 420, and 430. Graphs 445 in each FIG. 4A-4B illustrate porosity parameters (along horizontal axis) with well depth as a function of time (along vertical axis). Similarly in each FIG. 4A-4B, graphs 455 illustrate Vclay parameters; graphs 465 illustrate the water saturation models (Sw) assumed in the inversion; graphs 475 illustrate rock type classifications; and graphs 485 illustrate a masking parameter that informs the inversion of the fluid type (i.e. 1 is brine and -1 is hydrocarbon). In FIG. 4C, graph 445 illustrates porosity parameters (along horizontal axis) with well depth as a function of time (along vertical axis). Similarly in FIG. 4C, graph 455 illustrates Vclay parameters; graphs 490-a - 490-d illustrate four different angle stacks; and graph 495 illustrates a P-wave velocity parameter (e.g., frequency range 0-12 Hz). In the true model (e.g., well log data shown in the line WL of graphs 445 and 455 in FIG. 4C), on which seismic synthetic data are computed, zones 410 and 420 contain hydrocarbons, while zone 430 contains brine. In graphs 445 and 455 of FIG. 4C, the line INV is the inverted result (predicted result), and the line PR is the final prior distribution. For example, FIG. 4A illustrates porosity (in graph 445) and Vclay (in graph 455) after the first iteration. The two hydrocarbon reservoirs in zones 410 and 420 show large porosity values because the fluid assumption is violated. Graph 465 illustrates the water saturation model used during the inversion, indicative of starting with a brine flood assumption.

Method 203 continues at block 230 where rock types are classified based on the inverted porosity and Vclay from block 210. In FIG. 4A, note the classification of artificial rock type 6 in zones 410 and 420 of graph 475 based on the porosity and Vclay in graphs 445 and 455. In some embodiments, a machine learning system may be utilized to classify rock types based on iterative results, such as location of porosity and/or Vclay parameters in cross-plot space, data misfits, etc. Additionally, 3-D information could be included to further constrain the placement of sands.

Method 203 continues at block 250 where a fluid saturation model is generated based on the rock types from block 230. For example, based on the artificial rock type classification of graph 475, the two upper sands are switched from wet sands to hydrocarbon-bearing, as illustrated in the masking parameter of graph 485.

Method 203 continues at block 270 where an iteration of petrophysical inversion is performed based on the fluid saturation model of block 250. FIG. 4B illustrates results after the next iteration, utilizing masking parameters from graph 485 of FIG. 4A and water saturation model 465 of FIG. 4B. The water saturation in this example is computed as a function of Vclay. Note that this iteration employs a more complex fluid saturation model than the simple, brine flood assumption of the first iteration.

Method 203 continues at block 280 where an iteration of checking for convergence is performed. Note that no artificial rock type 6 is identified in graph 475 of FIG. 4B. Consequently, it can be assumed that zones 410 and 420 have been predicted correctly after two iterations. In the illustration of FIGs. 4A-4C, therefore, method 203 concludes at block 290, outputting a final fluid saturation model. FIG. 4C illustrates the final results. As can be seen in graphs 445 and 455 of FIG. 4C, the fluid types in each zone 410, 420, and 430 are predicted correctly during the inversion.

In some embodiments, block 580 identifies lack of convergence in the iterative fluid saturation model. In those instances, method 203 iteratively repeats blocks 230, 250, 270, and 280. For example method 203 might iterate until the rock type classification at block 230 converges. For example, with convergence, there is no change in the rock type classification from one iteration to the next. As another example, with convergence, the inverted porosity and Vclay would not change given the same facies and input data. In some embodiments, a specified number of iterations are performed before proceeding to block 290.

In some embodiments, a more sophisticated machine learning approach, such as deep learning, may be utilized to identify hydrocarbon sands when inverting under a brine flood assumption. Such an approach might include constraints on 3-D distributions of hydrocarbon sands, and further constraining where hydrocarbon sand can be found. For example, once there is a transition from hydrocarbon to wet for a given reservoir, there should be no hydrocarbon further downdip. In other words there should be a single fluid contact. Instead of using a simple classification as used in the example in a 1-D sense (trace by trace), a 3-D neural network may be trained to identify hydrocarbon sands in a brine flood based on the anomalous porosity and Vclay values. As before, the misfit-based approach and the classification-during-inversion approach may be utilized in conjunction to lessen or remove ambiguity between an actual fluid response and an unexpected lithology variation.

In practical applications, several of the embodiments described herein must be used in conjunction with, and/or carried out using, a seismic data analysis system (e.g., a high-speed computer) programmed in accordance with the disclosures herein. For example, any of the petrophysical or other inversion techniques will in various of these embodiments be carried out using such a system. Likewise, generating the various models (e.g., trial fluid saturation models and/or fluid saturation models) will be carried out using such as system, according to various of these embodiments. Identification of misfits may also be carried out using such a system (e.g., automated or semi-automated identification), although it will be appreciated that such identification may be carried out in whole or in part by user input. Such a seismic data analysis system may be referred to in generic shorthand simply as a "computer." The same or a different computer (and/or seismic data analysis system) may be used to carry out different inversions, and/or different steps of generating a model and/or displaying an image of a subsurface region.

Preferably, in order to effectively perform petrophysical inversion according to various embodiments herein, the seismic data analysis system is a high performance computer (HPC), as known to those skilled in the art. Such high performance computers typically involve clusters of nodes, each node having multiple central processing units (CPUs) and computer memory that allow parallel computation. The models may be visualized and edited using any interactive visualization programs and associated hardware, such as monitors and projectors. The architecture of the system may vary and may be composed of any number of suitable hardware structures capable of executing logical operations and displaying the output according to the present technological advancement. Those of ordinary skill in the art are aware of suitable supercomputers available from Cray or IBM.

As will be appreciated from the above discussion, in certain embodiments of the present approach, expert inputs are elicited that will have the most impact on the efficacy of a learning algorithm employed in the analysis, such as a classification or ranking algorithm, and which may involve eliciting a judgment or evaluation of classification or rank (e.g., right or wrong, good or bad) by the reviewer with respect to a presented query. Such inputs may be incorporated in real time in the analysis of seismic data, either in a distributed or non-distributed computing framework. In certain implementations, queries to elicit such input are generated based on a seismic data set undergoing automated evaluation, and the queries are sent to a workstation for an expert to review.

FIG. 5 illustrates a block diagram of a seismic data analysis system 9900 upon which the present technological advancement may be embodied. A central processing unit (CPU) 9902 is coupled to system bus 9904. The CPU 9902 may be any general-purpose CPU, although other types of architectures of CPU 9902 (or other components of exemplary system 9900) may be used as long as CPU 9902 (and other components of system 9900) supports the operations as described herein. Those of ordinary skill in the art will appreciate that, while only a single CPU 9902 is shown in FIG. 5, additional CPUs may be present. Moreover, the system 9900 may comprise a networked, multi-processor computer system that may include a hybrid parallel CPU/GPU system. The CPU 9902 may execute the various logical instructions according to various teachings disclosed herein. For example, the CPU 9902 may execute machine-level instructions for performing processing according to the operational flow described.

The seismic data analysis system 9900 may also include computer components such as non-transitory, computer-readable media. Examples of computer-readable media include a random access memory (RAM) 9906, which may be SRAM, DRAM, SDRAM, or the like. The system 9900 may also include additional non-transitory, computer-readable media such as a read-only memory (ROM) 9908, which may be PROM, EPROM, EEPROM, or the like. RAM 9906 and ROM 9908 hold user and system data and programs, as is known in the art. The system 9900 may also include an input/output (I/O) adapter 9910, a communications adapter 9922, a user interface adapter 9924, and a display adapter 9918; the system 9900 may potentially also include one or more graphics processor units (GPUs) 9914, and one or more display drivers 9916.

The I/O adapter 9910 may connect additional non-transitory, computer-readable media such as storage device(s) 9912, including, for example, a hard drive, a compact disc (CD) drive, a floppy disk drive, a tape drive, and the like to seismic data analysis system 9900. The storage device(s) may be used when RAM 9906 is insufficient for the memory requirements associated with storing data for operations of the present techniques. The data storage of the system 9900 may be used for storing information and/or other data used or generated as disclosed herein. For example, storage device(s) 9912 may be used to store configuration information or additional plug-ins in accordance with the present techniques. Further, user interface adapter 9924 couples user input devices, such as a keyboard 9928, a pointing device 9926 and/or output devices to the system 9900. The display adapter 9918 is driven by the CPU 9902 to control the display on a display device 9920 to, for example, present information to the user. For instance, the display device may be configured to display visual or graphical representations of any or all of the models discussed herein (e.g., fluid saturation models, porosity models, Vclay models, rock type models, seismic images, feature probability maps, feature objects, predicted labels of geologic features in seismic data, etc.). As the models themselves are representations of geophysical data, such a display device may also be said more generically to be configured to display graphical representations of a geophysical data set, which geophysical data set may include the models and data representations (including models and representations labeled with features predicted by a trained ML model) described herein, as well as any other geophysical data set those skilled in the art will recognize and appreciate with the benefit of this disclosure.

The architecture of seismic data analysis system 9900 may be varied as desired. For example, any suitable processor-based device may be used, including without limitation personal computers, laptop computers, computer workstations, and multi-processor servers. Moreover, the present technological advancement may be implemented on application specific integrated circuits (ASICs) or very large scale integrated (VLSI) circuits. In fact, persons of ordinary skill in the art may use any number of suitable hardware structures capable of executing logical operations according to the present technological advancement. The term "processing circuit" encompasses a hardware processor (such as those found in the hardware devices noted above), ASICs, and VLSI circuits. Input data to the system 9900 may include various plug-ins and library files. Input data may additionally include configuration information.

Seismic data analysis system 9900 may include one or more machine learning architectures. The machine learning architectures may be trained on various training data sets, e.g., as described in connection with various methods herein. The machine learning architectures may be applied to analysis and/or problem solving related to various unanalyzed data sets (e.g., test data such as acquired seismic or other geophysical data, as described herein). It should be appreciated that the machine learning architectures perform training and/or analysis that exceed human capabilities and mental processes. The machine learning architectures, in many instances, function outside of any preprogrammed routines (e.g., varying functioning dependent upon dynamic factors, such as data input time, data processing time, data set input or processing order, and/or a random number seed). Thus, the training and/or analysis performed by machine learning architectures is not performed by predefined computer algorithms and extends well beyond mental processes and abstract ideas.

The above-described techniques, and/or systems implementing such techniques, can further include hydrocarbon management based at least in part upon the above techniques. For instance, methods according to various embodiments may include managing hydrocarbons based at least in part upon fluid saturation models constructed according to the above-described methods. In particular, such methods may include drilling a well, and/or causing a well to be drilled, based at least in part upon the fluid saturation models (e.g., such that the well is located based at least in part upon a location determined from the fluid saturation models, which location may optionally be informed by other inputs, data, and/or analyses, as well) and further prospecting for and/or producing hydrocarbons using the well.

The foregoing description is directed to particular example embodiments of the present technological advancement. It will be apparent, however, to one skilled in the art, that many modifications and variations to the embodiments described herein are possible. Persons skilled in the art will readily recognize that in preferred embodiments of the invention, some or all of the steps in the present inventive method are performed using a computer, i.e., the invention is computer implemented. In such cases, the fluid saturation models (and/or images generated of a subsurface region based on such models) may be downloaded or saved to computer storage, and/or displayed using a computer and/or associated display.

## Claims

1. A method for generating a fluid saturation model for a subsurface region comprising:
performing (215) a first petrophysical inversion for the subsurface region with hydrocarbon flood parameters to generate hydrocarbon flood results;
performing (210) a second petrophysical inversion for the subsurface region with brine flood parameters to generate brine flood results;
identifying (220) a first set of misfits between the hydrocarbon flood results and one or both of a prior distribution and a true model;
identifying (220) a second set of misfits between the brine flood results and one or both of a prior distribution and a true model;
generating (250) a trial fluid saturation model based on at least one of the first set of misfits and the second set of misfits;
performing (270) a third petrophysical inversion for the subsurface region with the trial fluid saturation model to generate final results;
generating (290) the fluid saturation model for the subsurface region based on the final results; and
managing hydrocarbons in the subsurface region based on the fluid saturation model, wherein managing hydrocarbons comprises causing a well to be drilled;
wherein each one of the first, second, and third petrophysical inversion is carried out using a computer, and each one of the trial fluid saturation model and the fluid saturation model is generated using a computer.

2. The method of claim 1, wherein at least one of the first, second, and third petrophysical inversions comprises a facies-based inversion.

3. The method of claim 1 or 2, wherein at least one of the first set of misfits and the second set of misfits comprises at least one of
porosity misfits;
volume of clay misfits;
seismic data misfits; and
P-wave velocity misfits.

## Patentansprüche

1. Verfahren zum Erzeugen eines Fluidsättigungsmodells einer unterirdischen Region mit:
Durchführen (215) einer ersten petrophysikalischen Invertierung der unterirdischen Region mit Kohlenwasserstoffflutungsparametern, um Kohlenwasserstoffflutungsresultate zu erzeugen,
Durchführen (210) einer zweiten petrophysikalischen Invertierung der unterirdischen Region mit Salzlösungsflutungsparametern, um Salzlösungsflutungsresultate zu erzeugen,
Identifizieren (220) eines ersten Satzes von Abweichungen zwischen den Kohlenwasserstoffflutungsresultaten und von einem oder beiden von einer früheren Verteilung und einem wahren Modell,
Identifizieren (220) eines zweiten Satzes von Abweichungen zwischen den Salzlösungsflutungsresultaten und einem oder beiden von einer früheren Verteilung und einem wahren Modell,
Erzeugen (250) eines versuchsweisen Fluidsättigungsmodells basierend auf wenigstens einem von dem ersten Satz von Abweichungen und dem zweiten Satz von Abweichungen,
Durchführen (270) einer dritten petrophysikalischen Invertierung für die unterirdische Region mit dem versuchsweisen Fluidsättigungsmodell, um finale Resultate zu erzeugen,
Erzeugen (290) des Fluidsättigungsmodells für die unterirdische Region basierend auf den finalen Resultaten und
Managen von Kohlenwasserstoffen in der unterirdischen Region basierend auf dem Fluidsättigungsmodell, wobei das Managen der Kohlenwasserstoffe die Veranlassung der Bohrung eines Loches beinhaltet,
wobei jede von der ersten, zweiten und dritten petrophysikalischen Invertierung unter Verwendung eines Computers ausgeführt wird und jedes von dem versuchsweisen Fluidsättigungsmodell und dem Fluidsättigungsmodell unter Verwendung eines Computers erzeugt wird.

2. Verfahren nach Anspruch 1, wobei wenigstens eine von der ersten, zweiten und dritten petrophysikalischen Invertierung eine Fazies-basierte Invertierung beinhaltet.

3. Verfahren nach Anspruch 1 oder 2, wobei wenigstens einer von dem ersten Satz von Abweichungen und dem zweiten Satz von Abweichungen wenigstens eine oder mehrere von aufweist:
Porositätsabweichungen,
Tonvolumenabweichungen,
Abweichungen seismischer Daten und
P-Wellen-Geschwindigkeits-Abweichungen.

## Revendications

1. Procédé de génération d'un modèle de saturation en fluide pour une région de sous-sol, comprenant :
la réalisation (215) d'une première inversion pétrophysique pour la région de sous-sol avec des paramètres d'inondation aux hydrocarbures dans le but de générer des résultats d'inondation aux hydrocarbures ;
la réalisation (210) d'une deuxième inversion pétrophysique pour la région de sous-sol avec des paramètres d'inondation à la saumure dans le but de générer des résultats d'inondation à la saumure ;
l'identification (220) d'un premier ensemble de désaccords entre les résultats d'inondation aux hydrocarbures et une distribution antérieure et/ou un modèle vrai ;
l'identification (220) d'un deuxième ensemble de désaccords entre les résultats d'inondation à la saumure et une distribution antérieure et/ou un modèle vrai ;
la génération (250) d'un modèle de saturation en fluide d'essai sur la base du premier ensemble de désaccords et/ou du deuxième ensemble de désaccords ;
la réalisation (270) d'une troisième inversion pétrophysique pour la région de sous-sol avec le modèle de saturation en fluide d'essai dans le but de générer des résultats finaux ;
la génération (290) du modèle de saturation en fluide pour la région de sous-sol sur la base des résultats finaux ; et
la gestion d'hydrocarbures dans la région de sous-sol sur la base du modèle de saturation en fluide, la gestion d'hydrocarbures comprenant le déclenchement du forage d'un puits ;
les première, deuxième et troisième inversions pétrophysiques étant chacune mises en œuvre à l'aide d'un ordinateur, et le modèle de saturation en fluide d'essai et le modèle de saturation en fluide étant chacun générés à l'aide d'un ordinateur.

2. Procédé selon la revendication 1, dans lequel au moins une des première, deuxième et troisième inversions pétrophysiques comprend une inversion basée sur les faciès.

3. Procédé selon la revendication 1 ou 2, dans lequel le premier ensemble de désaccords et/ou le deuxième ensemble de désaccords comprennent/comprend :
des désaccords de porosité ;
des désaccords de volume d'argile ;
des désaccords de données sismiques ; et
des désaccords de vitesse des ondes P.
